# EUROPEAN PATENT APPLICATION

(11) **EP 4 682 973 A1**
(43) Date of publication of application: **21.01.2026**
(21) Application number: 25175306.7
(22) Date of filing: 09.05.2025
(51) Int. Cl.: H01M 4/133, G01R 31/392, H01M 4/38, H01M 4/587, H01M 10/42, H01M 10/0525

(54) **METHOD AND SYSTEM FOR DETECTING DEFECTIVE CELLS**

(30) Priority: 26.06.2024 KR 20240083616
(71) Applicant: SAMSUNG SDI CO., LTD., Yongin-si, Gyeonggi-do 17084 (KR)
(72) Inventor: KIM, Minsoo, 17084 Yongin-si (KR); KA, Bokhyun, 17084 Yongin-si (KR); KWON, Moon-Seok, 17084 Yongin-si (KR)
(74) Representative: Marks & Clerk LLP

(57) **Abstract**

The present disclosure provides a method for detecting a defective cell. The method may include: charging a cell in a manner that the state of charge (SOC) of the cell falls within a reference range, obtaining first charge data including differential voltage information of a negative electrode of the cell while the cell is being charged, where the negative electrode includes graphite and silicon, calculating a charging parameter associated with the silicon of the negative electrode based on the first charge data, and determining whether the cell is defective based on the charging parameter associated with the silicon.

## Description

### BACKGROUND

### 1. Field

Aspects of embodiments of the present disclosure relate to a method and system for detecting defective cells.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

A defect in a secondary battery may cause an issue, such as a fire. For example, lithium metal precipitated from the negative electrode due to a defect in the negative electrode of the secondary battery may reduce the lifespan of the secondary battery and cause an issue, such as a fire. To detect such a defect in a secondary battery, related-art techniques have been utilized to disassemble the secondary battery and check the state of the negative electrode of the cell by utilizing an electron microscope or the like. However, in these related-art techniques, there is an inconvenience of having to disassemble the cell to diagnose the internal state of the secondary battery, and there is also a chance that normal/functional cells have to be discarded after being disassembled.

The above information disclosed in this Background section is for enhancement of understanding of the background of the present disclosure, and therefore, it may contain information that does not constitute related (or prior) art.

### SUMMARY

One or more embodiments of the present disclosure may be direct toward a method and system for detecting defective cells.

These and other aspects and features of the present disclosure will be described in or will be apparent from the following description of embodiments of the present disclosure.

According to one or more embodiments of the present disclosure, a method for detecting a defective cell may include charging a cell in a manner that the state of charge (SOC) of the cell falls within a reference range, obtaining first charge data including differential voltage information of a negative electrode of the cell while the cell is being charged, where the negative electrode includes graphite and silicon, calculating a charging parameter associated with the silicon of the negative electrode based on the first charge data, and determining whether the cell is defective based on the charging parameter associated with the silicon.

In one or more embodiments, the method may further include outputting information related to the cell in response to determining that the cell is defective.

In one or more embodiments, the charging parameter associated with the silicon may be associated with the state of electrolyte impregnation of the negative electrode.

In one or more embodiments, the C-rate during charging of the cell may be higher than a reference threshold.

In one or more embodiments, the reference range may be a SOC range of 85 percent or higher.

In one or more embodiments, the charging parameter associated with the silicon may be determined based on a reference value and differences between differential voltage values of the negative electrode in the reference range of the cell.

In one or more embodiments, the charging parameter associated with the silicon may include a silicon-dominant response peak.

In one or more embodiments, the determining whether the cell is defective may include determining whether the cell is defective based on the charging parameter associated with the silicon and the reference threshold, and the reference threshold may be determined based on the capacity retention ratio according to an electrolyte content.

In one or more embodiments, the cell may be a cell that has undergone a formation process.

In one or more embodiments, the method may further include applying a re-formation process to the cell in response to determining that the cell is defective.

In one or more embodiments, the method may further include obtaining second charge data after the re-formation process of the cell, and determining whether the cell is defective based on the second charge data.

According to one or more embodiments of the present disclosure, a system for detecting a defective cell of the present disclosure includes a communication module, a memory, and at least one processor connected to the memory and configured to execute instructions stored in the memory to cause the at least one processor to perform a method including: charging a cell in a manner that a state of charge (SOC) of the cell falls within a reference range, obtaining first charge data including differential voltage information of a negative electrode of the cell while the cell is being charged, where the negative electrode includes graphite and silicon, calculating a charging parameter associated with the silicon of the negative electrode based on the first charge data, and determining whether the cell is defective based on the charging parameter associated with the silicon.

In one or more embodiments, the instructions may cause the at least one processor to perform the method further including: outputting information related to the cell in response to determining that the cell is defective.

In one or more embodiments, the charging parameter associated with the silicon may be associated with the state of electrolyte impregnation of the negative electrode.

In one or more embodiments, the C-rate during charging of the cell may be higher than a reference threshold.

In one or more embodiments, the reference range may be a SOC range of 85 percent or higher.

In one or more embodiments, the charging parameter associated with the silicon may be determined based on a reference value and differences between differential voltage values of the negative electrode in the reference range of the cell.

In one or more embodiments, to determine whether the cell is defective, the instructions may cause the at least one processor to perform the method further including: determining whether the cell is defective based on the charging parameter associated with the silicon and the reference threshold, and the reference threshold may be determined based on the capacity retention ratio according to an electrolyte content.

In one or more embodiments, the cell may be a cell that has undergone a formation process, and the instructions may cause the at least one processor to perform the method further including: applying a re-formation process to the cell in response to determining that the cell is defective.

In one or more embodiments, the instructions may cause the at least one processor to perform the method further including: obtaining second charge data after the re-formation process of the cell, and determining whether the cell is defective based on the second charge data.

According to one or more embodiments of the present disclosure, it is possible to detect a defective cell through electrochemical analysis without disassembling the cell. Accordingly, the user may easily detect defective cells simply by charging the cells, and the reliability of detecting defective cells may be improved.

According to one or more embodiments of the present disclosure, a defective cell may be detected non-destructively. In addition, through the re-formation process, the electrolyte impregnation of defective cells may be improved or repaired, and the defective anode active material may be stabilized, and cells that are not improved through the re-formation process may be processed as being defective. Accordingly, the reliability of defective cell detection may be improved.

These and other aspects and features of the present disclosure will be described in or will be apparent from the following description of embodiments of the present disclosure.

However, aspects and features of the present disclosure are not limited to those described above, and other aspects and features not mentioned will be clearly understood by a person skilled in the art from the detailed description, described below.

At least some of the above and other features of the invention are set out in the claims.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a diagram illustrating an example of a method for detecting a defective cell in one or more embodiments of the present disclosure.
FIG. 2 is a schematic diagram showing a configuration, in which an information processing system is connected to plural user terminals for communication to detect defective cells in one or more embodiments of the present disclosure.
FIG. 3 is a block diagram showing the internal structure of a user terminal and an information processing system in one or more embodiments of the present disclosure.
FIG. 4 is a diagram showing an example of the internal configuration of a processor of the information processing system of FIG. 3 in one or more embodiments of the present disclosure.
FIG. 5 is a diagram showing an example of a graph illustrating a change in differential voltage with charging in one or more embodiments of the present disclosure.
FIG. 6 is a diagram showing an example of a charge capacity of the negative electrode with the charge C-rate in one or more embodiments of the present disclosure.
FIG. 7 is a diagram showing an example of a graph illustrating a change in differential voltage with an electrolyte content in one or more embodiments of the present disclosure.
FIG. 8 is a diagram showing an example of a change in charge capacity of silicon with an electrolyte content in one or more embodiments of the present disclosure.
FIG. 9 is a diagram illustrating an example of a method for detecting a defective cell in one or more embodiments of the present disclosure.
FIG. 10 is a flowchart illustrating an example of a method for detecting a defective cell in one or more embodiments of the present disclosure.
FIG. 11 is a flowchart illustrating an example of a method for detecting a defective cell in one or more embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when a layer or element is referred to as being "between" two layers, it can be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C", "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of local patent laws.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In addition, the term 'module' or 'unit' utilized in the specification refers to a software or hardware component, and the 'module' or 'unit' performs specific roles. However, the 'module' or 'unit' is not limited to software or hardware. A 'module' or 'unit' may be configured to reside on an addressable storage medium and may be configured to drive one or more processors. Thus, as an example, a 'module' or 'unit' may include at least one of components, such as software components, object-oriented software components, class components and task components, processes, functions, attributes, procedures, subroutines, program code segments, drivers, firmware, microcode, circuits, data, databases, data structures, tables, arrays, and/or variables. Components and modules or units may be combined into a smaller number of larger ones or may be divided into a larger number of smaller ones, while maintaining the same functionality.

In one or more embodiments of the present disclosure, a 'module' or 'unit' may be implemented with a processor and a memory. The term 'processor' should be interpreted broadly to include a general-purpose processor, central processing unit (CPU), microprocessor, digital signal processor (DSP), controller, microcontroller, state machine, and the like. In some contexts, the 'processor' may refer to an application-specific integrated circuit (ASIC), programmable logic device (PLD), field programmable gate array (FPGA), and/or the like. The 'processor' may refer to, for example, a combination of a DSP and a microprocessor, a combination of plural microprocessors, a combination of one or more microprocessors coupled with a DSP core, or a combination of other processing devices. In addition, the term 'memory' should be interpreted broadly to include any electronic component capable of storing electronic information. The 'memory' may refer to various types of processor-readable media such as random access memory (RAM), read-only memory (ROM), non-volatile random access memory (NVRAM), programmable read-only memory (PROM), erasable-programmable read-only memory (EPROM), electrically erasable PROM (EEPROM), flash memory, magnetic or optical data storage, and registers. A memory is said to be in electronic communication with a processor if the processor may read information from the memory and/or write information to the memory. The memory integrated into a processor is in electronic communication with the processor.

In the present disclosure, the term 'system' may include, but not limited to, at least one of a server device and a cloud device. For example, a system may be composed of one or more server devices. As another example, a system may be composed of one or more cloud devices. As another example, a system may be configured to operate together with a server device and a cloud device.

In this disclosure, the term 'display' may refer to any display device associated with a computing device. For example, it may refer to a specific display device that is controlled by the computing device or is capable of displaying information/data provided by the computing device.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

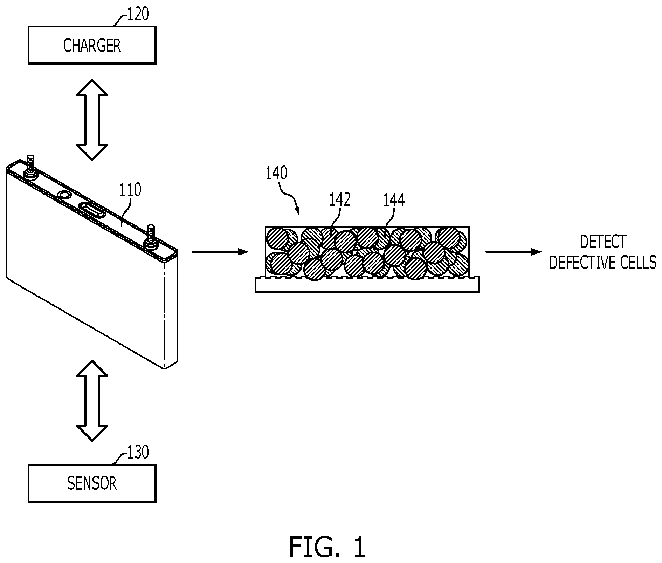

FIG. 1 is a diagram showing an example of a method for detecting a defective cell in one or more embodiments of the present disclosure. In one or more embodiments, a cell 110 that has undergone a formation process may be connected to a charger 120 and a sensor 130. In this case, the charger 120 may charge the cell 110, so that the state-of-charge (SOC) of the cell 110 falls within a reference range (e.g., a reference range may refer to a set or predetermined range of the SOC that may be utilized as a reference to determine whether a cell is defective or not. A SOC of a cell may be a measurement of the amount of charge remaining in the cell compared to its maximum capacity. For example, the SOC of the cell is 60%, which means that currently this cell has 60% capacity remaining. Here, a reference range of the SOC of the cell may be associated with the state of electrolyte impregnation of the negative electrode of the cell 110. For example, the reference range may be 85 percent or higher. Additionally, a C-rate of the cell during charging of the cell may be higher than a reference threshold (e.g., the reference threshold may be a set or predetermined threshold which may be utilized to determine whether the cell is defective or not, such as 0.3 C and/or the like). The C-rate (current rate) of a cell may be a measurement of the speed at which the cell can be charged or discharged. Further, the sensor 130 may measure the voltage, current, and/or the like of the cell 110 while the cell 110 is being charged.

In one or more embodiments, the processor (e.g., at least one processor of an information processing system) may obtain charge data including differential voltage information of the negative electrode 140 of the cell 110 while the cell 110 is being charged. Here, the differential voltage information of the negative electrode 140 is the voltage profile differentiated while the battery is being charged and may represent the rate of change of voltage with respect to the amount of charge (Q). The negative electrode 140 may be a silicon-graphite mixed negative electrode containing silicon 142 and graphite 144.

In one or more embodiments, the processor may calculate a charging parameter associated with the silicon 142 of the negative electrode 140 based on the charge data. Here, the charging parameter associated with the silicon 142 may be associated with the state of electrolyte impregnation of the negative electrode. In one or more embodiments, if (e.g., when) the state of electrolyte impregnation of the negative electrode is good, the resistance of the negative electrode may decrease and the capacity of the negative electrode may increase. On the other hand, if (e.g., when) the state of electrolyte impregnation of the negative electrode 140 is poor, the resistance of the negative electrode may increase and the capacity of the negative electrode may decrease. For example, due to the difference in C-rate characteristics between the silicon 142 and the graphite 144, the charge capacity of the graphite 144 may be relatively lower than that of the silicon 142 in the reference range.

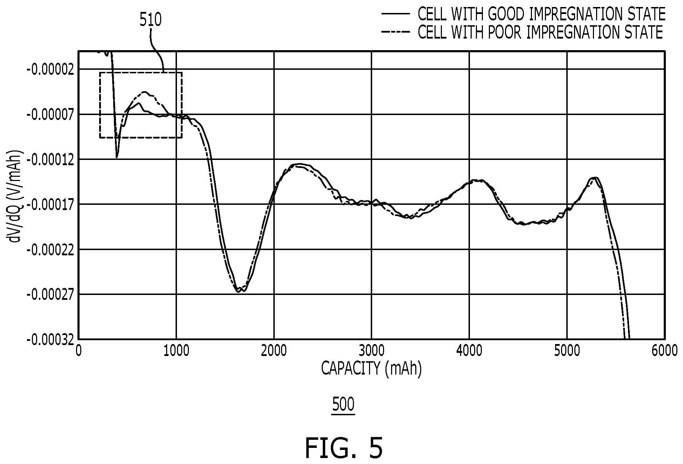

These points may also be identified through the charging parameter associated with the silicon 142 (e.g., silicon-dominant response peak in differential voltage information). As will be described in detail later with reference to FIG. 5, the charging parameter associated with the silicon 142 is the average of differences between differential voltage values of the negative electrode 140 in the reference range of the cell 110 and a reference value, and may be an indicator for determining the state of the negative electrode 140.

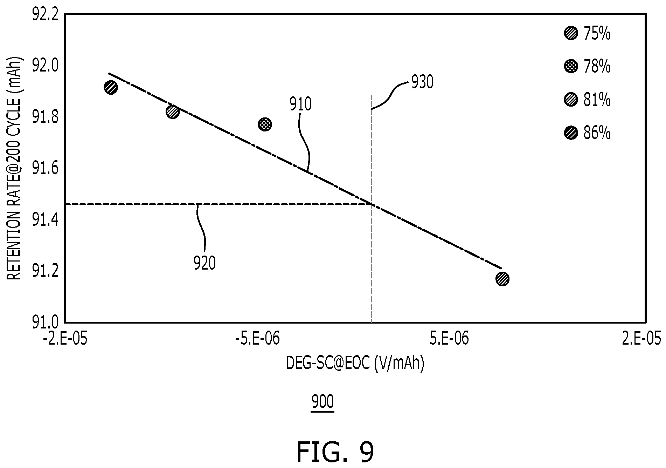

In one or more embodiments, the processor may determine whether the cell 110 is defective based on the charging parameter associated with the silicon 142. In one or more embodiments, the processor may determine whether the cell 110 is defective based on the charging parameter associated with the silicon 142 and the reference threshold (e.g., the reference threshold may be a set or predetermined threshold of 0.3 C and/or the like). An example of determining whether the cell 110 is defective is described in detail with reference to FIG. 9.

In one or more embodiments, in response to the cell 110 being determined to be defective, the processor may output information associated with the cell 110. Here, the information associated with the cell 110 may include, but not limited to, at least one of identification information of the cell 110, position information of the cell 110, voltage information of the cell 110, differential voltage information of the cell 110, the charging parameter of the cell 110, information indicating whether the cell 110 is defective, and/or information indicating whether a re-formation process is required. Thereby, the user may easily identify a cell that is to be processed as being defective and a cell that is to undergo a re-formation process through the information associated with the cell 110 displayed on the display.

With this configuration, a defective cell may be detected through electrochemical analysis without disassembling the cell. Consequently, the user may easily detect a defective cell simply by charging the cell, and the reliability of defective cell detection may be improved.

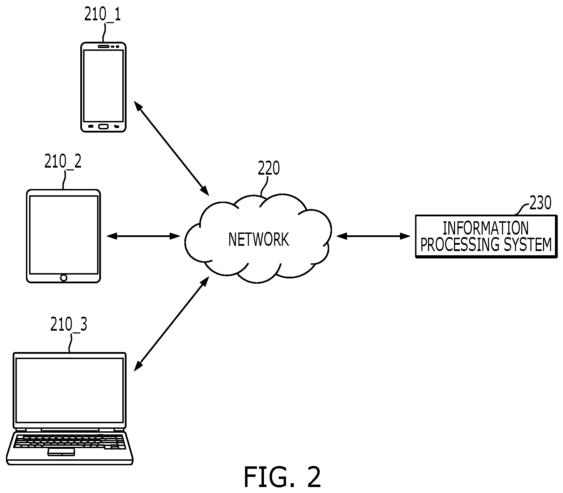

FIG. 2 is a schematic diagram showing a configuration, in which an information processing system 230 is connected to plural user terminals 210_1, 210_2, and 210_3 to enable communication for detecting a defective cell in one or more embodiments of the present disclosure. As shown, multiple user terminals 210_1, 210_2, and 210_3 may be connected through a network 220 to the information processing system 230 that may provide a defective cell determination service. Here, the plural user terminals 210_1, 210_2, and 210_3 may include a terminal of the user who receives a defective cell determination service.

In one or more embodiments, the information processing system 230 may include one or more server devices and/or databases that are capable of storing, providing, and/or executing computer-executable programs (e.g., downloadable applications) and data in connection with providing a defective cell determination service, or one or more distributed computing devices and/or distributed databases based on cloud computing services.

The defective cell determination service provided by the information processing system 230 may be delivered to the user through a defective cell determination application, web browser, and/or web browser extension installed on the plural user terminals 210_1, 210_2, and 210_3. For example, through the defective cell determination application and/or the like, the information processing system 230 may provide information corresponding to a request for defective cell determination received from the user terminals 210_1, 210_2, and 210_3, and/or perform corresponding processing.

The plural user terminals 210_1, 210_2, and 210_3 may communicate with the information processing system 230 through the network 220. The network 220 may be configured to enable communication between the plural user terminals 210_1, 210_2, and 210_3 and the information processing system 230. Depending on the installation environment, the network 220 may include (e.g., may be composed of), for example, a wired network such as Ethernet, wired home network (power line communication), telephone line communication or RS-serial communication, a wireless network such as mobile communication network, wireless LAN (WLAN), Wi-Fi, Bluetooth or ZigBee, and/or a combination thereof. There are no restrictions on communication schemes, and both communication schemes utilizing communication networks that the network 220 may include (e.g., mobile communication network, wired Internet, wireless Internet, broadcasting network, and/or satellite network) and short-range wireless communication between the user terminals 210_1, 210_2, and 210_3 may also be included.

In FIG. 2, a mobile phone terminal 210_1, a tablet terminal 210_2, and a PC terminal 210_3 are shown as examples of user terminals (e.g., the user terminals 210_1, 210_2, and 210_3); but without being limited thereto, the user terminals 210_1, 210_2, and 210_3 may be any computing device that is capable of wired and/or wireless communication and capable of installing and executing a defective cell determination application and/or a web browser. For example, the user terminals (e.g., the user terminals 210_1, 210_2, and 210_3) may include an AI speaker, a smartphone, a mobile phone, a navigation aid, a computer, a laptop, a digital broadcasting terminal, a personal digital assistant (PDA), a portable multimedia player (PMP), a tablet PC, a game console, a wearable device, an Internet-of-things (IoT) device, a virtual reality (VR) device, an augmented reality (AR) device, and/or a set-top box. In addition, in FIG. 2, three user terminals 210_1, 210_2, and 210_3 are shown as communicating with the information processing system 230 through the network 220. But without being limited thereto, a different number of user terminals may be configured to communicate with the information processing system 230 over the network 220.

In FIG. 2, a configuration, in which a user request (e.g., request for defective cell determination) is transferred to the information processing system 230 through the user terminals 210_1, 210_2, and 210_3, is shown as an example; but without being limited thereto, the user request may be provided to the information processing system 230 through an input device associated with the information processing system 230 without going through the user terminals 210_1, 210_2, and 210_3, and the result of processing the user request (e.g., whether the cell is defective) may be provided to the user through an output device (e.g., display) associated with the information processing system 230.

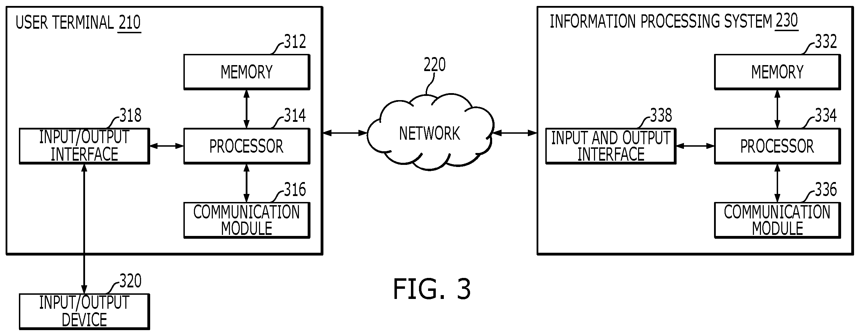

FIG. 3 is a block diagram showing the internal structure of the user terminal 210 and the information processing system 230 in one or more embodiments of the present disclosure. The user terminal 210 may refer to any computing device capable of executing an application and/or a web browser and capable of wired/wireless communication, and may include, for example, the mobile phone terminal 210_1, tablet terminal 210_2, and PC terminal 210_3 in FIG. 2. As shown, the user terminal 210 may include a memory 312, a processor 314, a communication module 316, and an input/output interface 318. Similarly, the information processing system 230 may include a memory 332, a processor 334, a communication module 336, and an input/output interface 338. As shown in FIG. 3, the user terminal 210 and the information processing system 230 may be configured to exchange information and/or data through the network 220 by utilizing their communication modules 316 and 336. In addition, the input/output device 320 may be configured to input information and/or data to the user terminal 210 through the input/output interface 318, or to output information and/or data generated from the user terminal 210.

The memory 312 or 332 (e.g., each of the memory 312 and the memory 332) may include any non-transitory computer-readable recording medium. In one or more embodiments, the memory 312 or 332 may include a permanent mass storage device, such as read only memory (ROM), disk drive, solid state drive (SSD), and/or flash memory. In one or more embodiments, a permanent mass storage device such as ROM, SSD, flash memory, and/or disk drive may be included in the user terminal 210 or the information processing system 230 as a separate permanent storage device that is distinct from the memory. In addition, the memory 312 or 332 may store an operating system and at least one program code.

These software components may be loaded from a computer-readable recording medium separate from the memory 312 or 332. This separate computer-readable recording medium may include a recording medium directly connectable to the user terminal 210 or the information processing system 230, and may include, for example, a computer-readable recording medium such as floppy drive, disk, tape, DVD/CD-ROM drive, and/or memory card. In one or more embodiments, software components may be loaded onto the memory 312 or 332 through the communication module 316 or 336 (e.g., either the communication module 316 or the communication module 336, correspondingly) other than a computer-readable recording medium. For example, at least one program may be loaded onto the memory 312 or 332 based on a computer program installed by files provided over the network 220 by developers or a file distribution system that distributes installation files for applications.

The processor 314 or 334 (e.g., each of the processor 314 and the processor 334) may be configured to process instructions of a computer program by performing basic arithmetic, logic, and/or input/output operations. These instructions may be provided to the processor 314 or 334 by the memory 312 or 332 or the communication module 316 or 336. For example, the processor 314 or 334 may be configured to execute received instructions according to a program code stored in a recording device, such as the memory 312 or 332 (e.g., correspondingly).

The communication modules 316 and 336 may provide a configuration or function for the user terminal 210 and the information processing system 230 to communicate with each other through the network 220, and may provide a configuration or function for the user terminal 210 and/or the information processing system 230 to communicate with other user terminals or other systems (e.g., a separate cloud system). For example, a request or data (e.g., request for defective cell determination) generated by the processor 314 of the user terminal 210 according to a program code stored in a recording device such as the memory 312 may be transmitted through the network 220 to the information processing system 230 under the control of the communication module 316. In reverse, a control signal or command provided under the control of the processor 334 of the information processing system 230 may be transmitted through the communication module 336 over the network 220 and received by the user terminal 210 through the communication module 316 of the user terminal 210.

The input/output interface 318 may be an interface (e.g., means) for interfacing with the input/output device 320. In one or more embodiments, input devices may include a device such as a camera including an audio sensor and/or an image sensor, a keyboard, a microphone, and/or a mouse, and output devices may include a device such as a display, a speaker, and/or a haptic feedback device. In one or more embodiments, the input/output interface 318 may be an interface (e.g., a means) for interfacing with a device whose structures or functions for performing input and output are integrated into one, such as a touchscreen. For example, if (e.g., when) the processor 314 of the user terminal 210 processes instructions of a computer program loaded onto the memory 312, a service screen and/or the like composed based on information and/or data provided by the information processing system 230 or another user terminal may be displayed on the display through the input/output interface 318. In FIG. 3, the input/output device 320 is shown as not being included in the user terminal 210, but without being limited thereto, it may be configured as a single device with the user terminal 210. In addition, the input/output interface 338 of the information processing system 230 may be an interface (e.g., means) for interfacing with a device for input or output that is capable of being connected to or included in the information processing system 230. In FIG. 3, the input/output interface 318 or 338 is shown as a separate component from the processor 314 or 334, but without being limited thereto, the input/output interface 318 or 338 may be configured to be included in the processor 314 or 334. For example, the input/output interface 318 may be configured to be included in the processor 314, and the input/output interface 338 may be configured to be included in the processor 334.

The user terminal 210 or the information processing system 230 may include more components than those shown in FIG. 3. In one or more embodiments, the user terminal 210 may be implemented to include at least some of the input/output device 320 described above. In addition, the user terminal 210 may further include other components, such as a transceiver, a global positioning system (GPS) module, a camera, various sensors, and/or a database. For example, if (e.g., when) the user terminal 210 is a smartphone, it may include those components included in a typical smartphone. For example, the user terminal 210 may be implemented to further include various components, such as an acceleration sensor, a gyro sensor, a microphone module, a camera module, various physical buttons, buttons utilizing a touch panel, input/output ports, and/or a vibrator for vibration.

While a program or application for the defective cell determination service is running, the processor 314 may receive text, image, video, voice, and/or action through input devices, such as a touchscreen, keyboard, camera including an audio sensor, and/or an image sensor, and/or a microphone connected to the input/output interface 318, and may store the received text, image, video, voice, and/or action in the memory 312 or provide the same to the information processing system 230 through the communication module 316 over the network 220.

The processor 314 of the user terminal 210 may be configured to manage, process, and/or store information and/or data received from the input/output device 320, another user terminal, the information processing system 230, and/or a plurality of external systems. The information and/or data processed by the processor 314 may be provided through the communication module 316 to the information processing system 230 over the network 220. The processor 314 of the user terminal 210 may transmit information and/or data through the input/output interface 318 to the input/output device 320 to output the same. For example, the processor 314 may output or display the received information and/or data to or on the screen associated with the user terminal 210.

The processor 334 of the information processing system 230 may be configured to manage, process, and/or store information and/or data received from a plurality of user terminals 210 and/or a plurality of external systems. The information and/or data processed by the processor 334 may be provided through the communication module 336 to the user terminal 210 over the network 220.

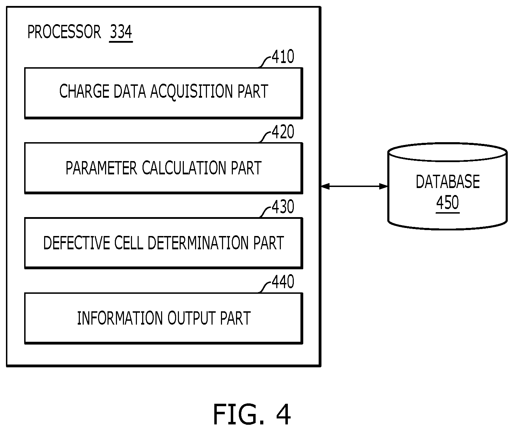

FIG. 4 is a diagram showing an example of the internal configuration of the processor 334 of the information processing system in one or more embodiments of the present disclosure. As illustrated, the processor 334 of the information processing system may include a charge data acquisition part 410, a parameter calculation part 420, a defective cell determination part 430, and an information output part 440. A single processor is shown in FIG. 4, but without being limited thereto, multiple processors may be configured.

The charge data acquisition part 410 may obtain first charge data associated with the cell while the cell is being charged. Here, the first charge data may include differential voltage information of the negative electrode of the cell. Additionally, the negative electrode of the cell may include graphite and/or silicon. The first charge data obtained by the charge data acquisition part 410 may be stored in a database 450.

In one or more embodiments, the charge data acquisition part 410 may generate a control signal to be applied to the charger (e.g., charger 120 in FIG. 1) and transmit it (e.g., the control signal) to the charger to obtain the first charge data. Here, the control signal may be a signal that controls charging of the charger, so that the SOC of the cell is within a reference range (e.g., a SOC range of 85 percent or higher), or the control signal may be a signal that controls the charge C-rate of the charger (e.g., the charge C-rate of 0.3 C or higher). For example, if (e.g., when) the SOC of the cell is 60 percent, the charge data acquisition part 410 may generate a signal for controlling the charging of the charger, so that the SOC of the cell becomes 100 percent (e.g., to be within the reference range of the SOC which is 85 percent or higher), and the charge data acquisition part 410 may transmit the signal to the charger.

The parameter calculation part 420 may calculate a charging parameter associated with silicon of the negative electrode of the cell based on the first charge data obtained by the charge data acquisition part 410. In one or more embodiments, the parameter calculation part 420 may calculate a charging parameter associated with silicon based on a differential voltage at a specific SOC of the cell. Here, the charging parameter associated with silicon may be associated with the state of electrolyte impregnation of the negative electrode. For example, the parameter calculation part 420 may produce the charging parameter associated with silicon by calculating the average of the differences between differential voltage values of the negative electrode collected while charging is in progress in 85 percent of a SOC or higher relative to 100 percent of the SOC and a reference value. The charging parameter calculated by the parameter calculation part 420 may be stored in the database 450.

The defective cell determination part 430 may determine whether the cell is defective based on the charging parameter associated with silicon calculated by the parameter calculation part 420. If (e.g., when) a cell having already undergone the formation process is determined to be defective, the defective cell determination part 430 may generate a control signal for performing a re-formation process on the corresponding cell.

In one or more embodiments, after the re-formation process of a cell having been determined to be defective, the charge data acquisition part 410 may obtain second charge data associated with the cell while charging is in progress, so that the SOC of the cell falls within a reference range (e.g., 85 percent or higher). Additionally, the parameter calculation part 420 may calculate again the charging parameter associated with silicon of the negative electrode based on the second charge data. Based on the recalculated charging parameter associated with silicon, the defective cell determination part 430 may determine again whether the cell is defective. If (e.g., when) the cell is determined to be defective again by the defective cell determination part 430, the cell may be finally processed/determined as being defective.

The information output part 440 may output information associated with the cell in response to the cell being determined to be defective (e.g., finally determined to be defective after the re-formation process). Here, the information associated with the cell is information stored in the database 450, and may include, but not limited to, at least one of identification information of the cell, position information of the cell, voltage information of the cell, differential voltage information of the cell, and/or charging parameter associated with silicon.

FIG. 5 is a diagram showing an example of a graph 500 illustrating a change in differential voltage with charging in one or more embodiments of the present disclosure. The graph 500 depicts a change in differential voltage of the negative electrode according to the charging of the cell. Additionally, a region 510 of the graph 500 indicates a change in differential voltage of the cell at a specific SOC (e.g., 85 percent of the SOC or higher relative to 100 percent of the SOC) of the cell. Referring to the graph 500, it may be identified in the region 510 that the differential voltage of a cell with poor electrolyte impregnation is higher than the differential voltage of a cell with good electrolyte impregnation. Since the C-rate characteristic of graphite included in the negative electrode is worse than that of silicon, if (e.g., when) the state of electrolyte impregnation is poor, the overvoltage due to the C- rate characteristic of graphite may increase. Hence, as the charge capacity of graphite decreases and the ratio of the charge capacity of silicon increases, the silicon-dominant response peak, where the differential voltage of the cell with poor electrolyte impregnation is higher, may become more prominent, as in the region 510. For example, for a cell with a better impregnation state, such a silicon-dominant response peak may be generated at a position closer to the left side of the graph 500 (e.g., a position where the capacity value is closer to 0).

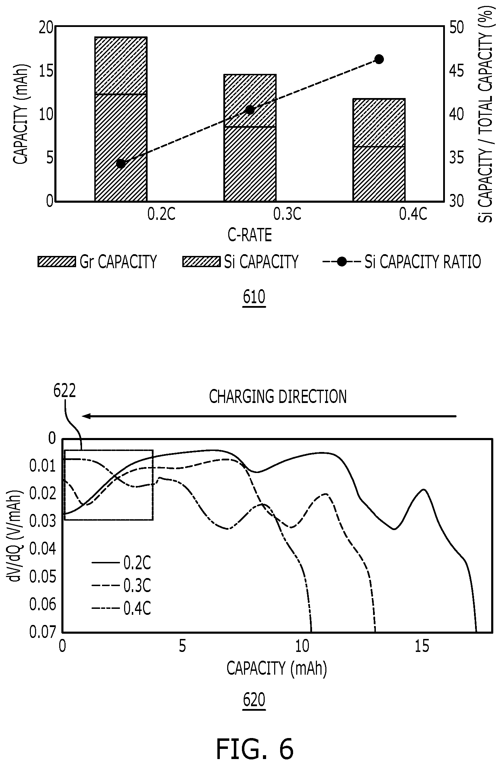

FIG. 6 is a diagram showing an example of the charge capacity of the negative electrode with the charge C-rate in one or more embodiments of the present disclosure. The first graph 610 shows changes in the charge capacity of graphite (Gr) and the charge capacity of silicon (Si) according to the charge C-rate of the negative electrode half-cell. Referring to the first graph 610, it may be seen that as the charge C-rate increases, the charge capacity of graphite decreases due to overvoltage. This overvoltage may be related to the internal resistance of the negative electrode. As a result, the ratio of the charge capacity of silicon to the charge capacity of graphite may increase as the charge C-rate increases.

The second graph 620 shows a change in the differential voltage according to the charging and charge C-rate of the negative electrode half-cell. Here, the differential voltage value of the negative electrode half-cell may be expressed as a positive number. Additionally, a region 622 of the second graph 620 indicates a change in the differential voltage of the negative electrode half-cell at a specific SOC (e.g., 85 percent of the SOC or higher relative to 100 percent of the SOC) of the negative electrode half-cell. Referring to the second graph 620, it may be identified in the region 622 that the absolute value of the differential voltage of the negative electrode half-cell decreases as the charge C-rate increases. In other words, as the charge C-rate increases, the charge capacity of graphite decreases due to the internal resistance of the negative electrode, so the absolute value of the differential voltage of the negative electrode half-cell may decrease due to an increase in the proportion of the charge capacity of silicon in the region 622. For example, in the region 622, the absolute value of the differential voltage of a negative electrode half-cell charged at a C-rate of 0.4 C may be less than the absolute value of the differential voltage of a negative electrode half-cell charged at a C-rate of 0.2 C.

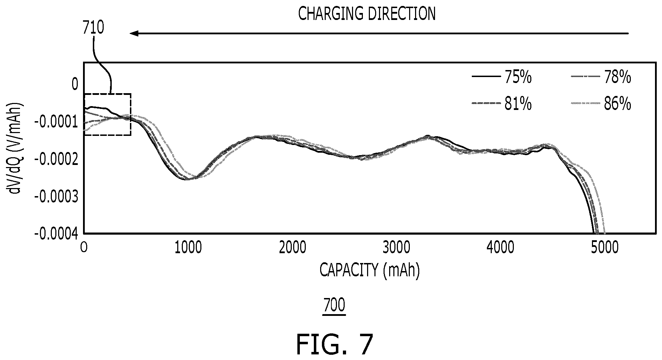

FIG. 7 is a diagram showing an example of a graph 700 depicting a change in differential voltage with an electrolyte content (e.g., amount) in one or more embodiments of the present disclosure. The graph 700 shows the change in differential voltage according to the charging and electrolyte content of a full cell. An electrolyte content of the cell may be an amount of electrolyte in the cell, e.g., a weight percentage of the electrolyte relative to 100 wt% of a total weight of the cell. Here, the differential voltage value of the negative electrode of the full cell may be expressed as a negative number. Additionally, a region 710 of the graph 700 indicates a change in differential voltage at a specific SOC (e.g., 85 percent of the SOC or higher relative to 100 percent of the SOC) of the full cell (e.g., 100 percent of the SOC). Referring to the graph 700, it may be identified in the region 710 that the absolute value of the differential voltage of a full cell with low electrolyte content is lower than the differential voltage of a full cell with high electrolyte content. If (e.g., when) the electrolyte content is low, the resistance of the negative electrode may increase or the electrolyte impregnation may occur unevenly. As a result, the charge capacity of graphite may be lowered, and thus the absolute value of the differential voltage of the full cell may be lowered due to an increase in the proportion of the charge capacity of silicon in the region 710. For example, in the region 710, the absolute value of the differential voltage of a full cell with an electrolyte content of 75 percent may be lower than the absolute value of the differential voltage of a full cell with an electrolyte content of 86 percent.

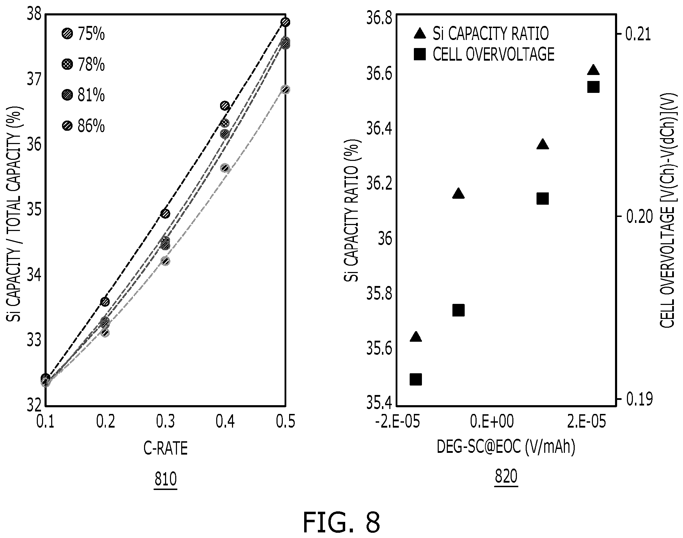

FIG. 8 is a diagram showing an example of a change in the charge capacity of silicon with the electrolyte content in one or more embodiments of the present disclosure. The first graph 810 depicts the change in the ratio of the charge capacity of silicon to the total charge capacity according to the charge C-rate and electrolyte content. Referring to the first graph 810, it may be identified that the ratio of the charge capacity of silicon to the total charge capacity of the cell increases with the increasing charge C-rate. In addition, it may be identified that even if (e.g., when) the cells are charged at the same charge C-rate, the ratio of the charge capacity of silicon to the total charge capacity is higher for a cell with a lower electrolyte content due to the difference in the C-rate characteristic of graphite contained in the negative electrode. In other words, if (e.g., when) the state of electrolyte impregnation of the negative electrode is poor, the ratio of the charge capacity of silicon to the charge capacity of the cell may increase.

The second graph 820 depicts the correlation between the charging parameter associated with the silicon of the negative electrode (deg-SC@EOC) and the ratio of the charge capacity of the silicon (e.g., the ratio of the charge capacity of silicon to the total charge capacity) at a specific SOC of the cell (e.g., 85 percent of the SOC or higher relative to 100 percent of the SOC). Here, the charging parameter associated with silicon may be associated with the state of electrolyte impregnation of the negative electrode. In addition, the charging parameter associated with silicon may be determined based on a reference value (e.g., a reference value may be a set or predetermined value that is a benchmark value/baseline based on data collected from normal cells to determine whether the cell is defective or not) and the differences between differential voltage values of the negative electrode in a reference range of the cell. The reference value may be the differential voltage value of a cell having a SOC of 85 percent and an electrolyte content/amount of 86 percent relative to 100 percent of the cell (e.g., 86 wt% of electrolyte relative to 100 wt% of a total weight of the cell), but without being limited thereto, it may be the differential voltage value at a point where the inflection occurs. In one or more embodiments, the charging parameter associated with silicon may be calculated to be the average of the differences between the differential voltage values of the negative electrode in a reference range of the cell and the reference value. Referring to the second graph 820, it may be seen that the charging parameter value associated with silicon is proportional to the ratio of the charge capacity of silicon and overvoltage of the cell (e.g., cell resistance). For example, an increase in the charge parameter value associated with silicon may imply an increase in the charge ratio of silicon and overvoltage of the cell. Conversely, an increase in the overvoltage of the cell or an increase in the ratio of the charge capacity of silicon may imply an increase in the charging parameter value associated with silicon.

FIG. 9 is a diagram illustrating an example of a method for detecting a defective cell in one or more embodiments of the present disclosure. The graph 900 shows a capacity retention ratio of the cell according to the electrolyte content and the charging parameter associated with silicon (deg-SC@EOC). The capacity retention ratio may be a ratio of the capacity of a cell after storage to its average capacity. Referring to the graph 900, the lower the electrolyte content of the cell, the lower the capacity retention ratio of the cell. Also, the lower the electrolyte content of the cell, the higher the charging parameter value associated with silicon. In other words, the worse the state of electrolyte impregnation of the negative electrode, the higher the charging parameter value associated with silicon may be.

In one or more embodiments, whether a cell is defective may be determined based on a charging parameter associated with silicon and a reference threshold. Here, the reference threshold may be determined based on the capacity retention ratio according to the electrolyte content. In one or more embodiments, a trend line 910 representing the relationship between the capacity retention ratio according to the electrolyte content and the charging parameter associated with silicon may be estimated. A linear regression algorithm may be utilized to estimate the trend line 910, without being limited thereto. In addition, a capacity retention specification 920 that serves as a reference for a normal cell may be determined in advance. In this case, at the point where the trend line 910 and the capacity retention specification 920 intersect, a reference threshold 930 associated with the charging parameter associated with silicon may be determined. Therefore, a cell having a charging parameter value associated with silicon exceeding the reference threshold 930 may be determined to be a defective cell.

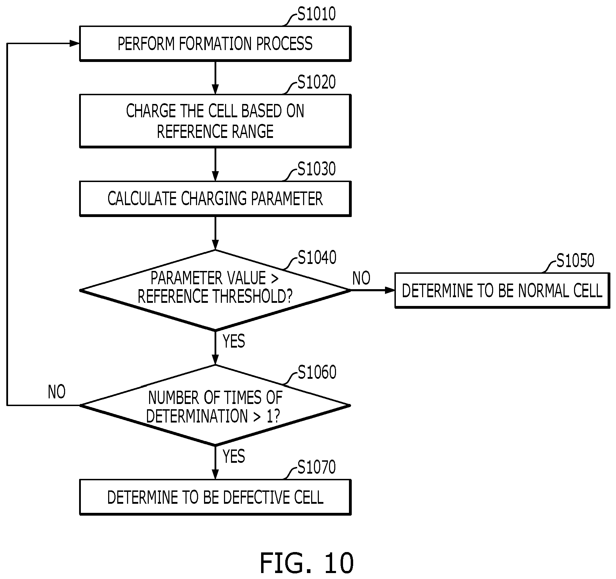

FIG. 10 is a diagram showing an example of a method for detecting a defective cell in one or more embodiments of the present disclosure. In one or more embodiments, the method for detecting a defective cell may be initiated by performing a formation process of a cell utilizing a formation process equipment (S1010). Then, the cell may be charged based on a reference range (e.g., SOC of 85 percent or higher) (S1020). In this case, the processor (e.g., processor 334 in FIG. 3) may obtain first charge data including differential voltage information of the negative electrode of the cell while the cell is being charged. Here, the negative electrode may include graphite and silicon.

Thereafter, the processor may calculate the charging parameter associated with silicon of the negative electrode based on the first charge data (S1030). Here, the charging parameter associated with silicon may be associated with the state of electrolyte impregnation of the negative electrode. Additionally, the charging parameter associated with silicon may be determined based on a reference value and the differences between differential voltage values of the negative electrode in a reference range of the cell.

Thereafter, the processor may determine whether the cell is defective based on the charging parameter value associated with silicon and the reference threshold (S1040). In one or more embodiments, the processor may compare the charging parameter value associated with silicon with the reference threshold. Here, the reference threshold may be determined based on the capacity retention ratio according to the electrolyte content. If (e.g., when) the charging parameter value associated with silicon of the cell is less than the reference threshold, the processor may determine the corresponding cell to be a normal cell (S1050). In this case, information indicating that the corresponding cell is a normal cell may be output to the display.

If (e.g., when) the charging parameter value associated with silicon of the cell is greater than the reference threshold, the processor may determine whether the number of times of determining whether the cell is defective is two or more (S1060). If (e.g., when) the number of times determining whether the cell is defective is one, a re-formation process may be performed on the corresponding cell to stabilize the defective cell (S1010). For example, the re-formation process may be performed utilizing a formation process equipment. Then, as described above, the cell on which the re-formation process has been performed may be charged based on the reference range (S1020). Additionally, the processor may obtain second charge data for the cell and, based on this (e.g., the second charge data), recalculate the charging parameter associated with silicon (S1030). In addition, the processor may determine again whether the cell is defective by comparing the newly calculated charging parameter value associated with silicon (e.g., the charging parameter value recalculated based on the second charge data) with the reference threshold (S1040).

If (e.g., when) the cell is still defective, the processor may determine the cell to be a defective cell since the number of times of determination is two (S1070). The processor may output information related to the cell in response to the cell being determined as defective (e.g., finally determined to be defective). Here, the information related to the cell may include, but not limited to, identification information of the cell, position information of the cell, voltage information of the cell, differential voltage information of the cell, and/or charging parameter associated with silicon.

By use of this configuration, defective cells may be detected non-destructively. In addition, through the re-formation process for a defective cell, the electrolyte impregnation may be improved, the defective anode active material may be stabilized, and a cell that is not improved through the re-formation process may be processed as being defective. Thereby, the reliability of defective cell detection may be improved.

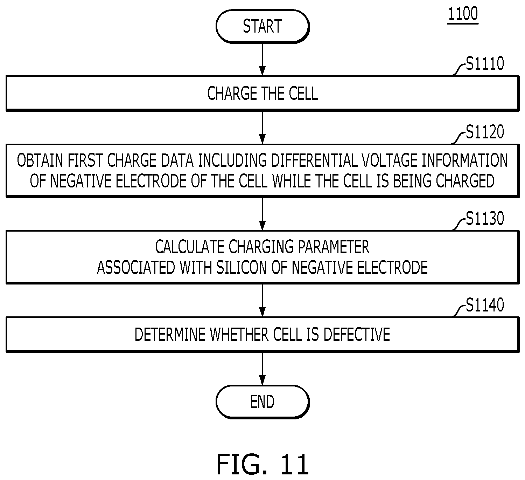

FIG. 11 is a flowchart illustrating an example of a method 1100 for detecting a defective cell in one or more embodiments of the present disclosure. In one or more embodiments, the defective cell detection method 1100 may be performed by at least one processor. The defective cell detection method 1100 may be initiated by the processor that starts the charging of the cell so that the state of charge (SOC) of the cell falls within a reference range (S1110). Here, the reference range may be an SOC range of 85 percent or higher. In addition, the C-rate while the cell is being charged may be higher than a reference threshold.

Thereafter, the processor may obtain first charge data including differential voltage information of the negative electrode of the cell while the cell is being charged (S1120). Here, the negative electrode may include graphite and/or silicon.

Thereafter, the processor may calculate a charging parameter associated with silicon of the negative electrode based on the first charge data (S1130). Here, the charging parameter associated with silicon may be related to the state of electrolyte impregnation of the negative electrode. In addition, the charging parameter associated with silicon may be determined based on a reference value and the differences between differential voltage values of the negative electrode in the reference range of the cell.

Thereafter, the processor may determine whether the cell is defective based on the charging parameter associated with silicon (S1140). In one or more embodiments, the processor may determine whether the cell is defective based on the charging parameter associated with silicon and a reference threshold. Here, the reference threshold may be determined based on the capacity retention ratio according to the electrolyte content. Further, the processor may output information related to the cell in response to determining that the cell is defective.

In one or more embodiments, the cell may be a cell that has undergone a formation process. In this case, in response to determining that the cell is defective, the processor may apply a re-formation process to the cell. Then, the processor may obtain second charge data after the re-formation process of the cell. Additionally, the processor may determine whether the cell is defective based on the second charge data.

The above-described method may be provided as a computer program stored in a computer-readable recording medium for execution on a computer. Media may be utilized to continuously store programs executable on a computer or to temporarily store them for execution or download. Additionally, the media may be a variety of recording or storage means in the form of a single piece of hardware or a combination of several pieces of hardware, and the media may be directly connected to a certain computer system or may be distributed over a network. Examples of the media may include magnetic media such as a hard disk, floppy disk and magnetic tape, optical recording media such as CD-ROM and DVD, magneto-optical media such as floptical disk, ROM, RAM, flash memory, which may be configured to store program instructions. Additionally, examples of other media may include recording or storage media managed by app stores that distribute applications, or by sites or servers that supply or distribute various other software.

The methods, operations, or techniques of the present disclosure may be implemented with various means. For example, these techniques may be implemented in hardware, firmware, software, or a combination thereof. Those skilled in the art will understand that the various illustrative logical blocks, modules, circuits, and algorithm steps described in connection with the present disclosure may be implemented in electronic hardware, computer software, and/or a combination thereof. To clearly illustrate this mutual replacement between hardware and software, various illustrative components, blocks, modules, circuits, and steps have been described above generally in terms of their functionality. Whether such functionality is implemented in hardware or software depends on the specific application and design requirements imposed on the overall system. Those skilled in the art may implement the described functionality in various ways for specific applications, but such implementations should not be construed as departing from the scope of the present disclosure.

In hardware implementation, the processing units utilized to perform the techniques may be implemented with one or more ASICs, DSPs, GPUs, digital signal processing devices (DSPDs), programmable logic devices (PLDs), field programmable gate arrays (FPGAs), processors, controllers, microcontrollers, microprocessors, electronic devices, other electronic units designed to perform the functions described in this disclosure, computers, and/or a combination thereof.

Thus, the various example logical blocks, modules, and circuits described in connection with the present disclosure may be implemented with or performed by general-purpose processors, DSPs, ASICs, FPGAs, programmable logic devices, discrete gates, transistor logics, discrete hardware components, and/or any combination thereof designed to perform the functions described herein. A general-purpose processor may be a microprocessor, but alternatively, the processor may be any processor, controller, microcontroller, or state machine. The processors may also be implemented as a combination of computing devices, such as a DSP and a microprocessor, a plurality of microprocessors, one or more microprocessors in conjunction with a DSP core, and/or any other configurations.

In firmware and/or software implementation, the techniques may be implemented as instructions stored in a computer-readable medium such as random access memory (RAM), read-only memory (ROM), non-volatile random access memory (NVRAM), programmable read-only memory (PROM), erasable programmable read-only memory (EPROM), electrically erasable PROM (EEPROM), flash memory, compact disc (CD), and/or magnetic or optical data storage device. The instructions may be executable by one or more processors, and may cause the processor(s) to perform certain aspects of the functionality described in the present disclosure.

If (e.g., when) implemented in software, the techniques may be stored in or transmitted through computer-readable media as one or more instructions or code. The computer-readable media include both computer storage media and communication media by including any media that facilitate transfer of a computer program from one place to another. The storage media may be any available media that may be accessed by a computer. By way of non-limiting examples, these computer readable media may include RAM, ROM, EEPROM, CD-ROM or other optical disk storage, magnetic disk storage or other magnetic storage devices, and/or any other media that may be utilized to transport or store desired program codes in the form of instructions or data structures and may be accessed by a computer. In addition, random access may be suitably made to computer-readable media.

For example, if (e.g., when) software is transmitted from a website, server, or other remote source by utilizing coaxial cable, fiber optic cable, twisted pair cable, digital subscriber line (DSL), or wireless technologies such as infrared ray, radio wave, and microwave, these coaxial cable, fiber optic cable, twisted pair cable, digital subscriber line, or wireless technologies such as infrared ray, radio wave, and microwave may be included in the definition of media. As utilized herein, disks and discs include CD, laser disc, optical disc, digital versatile disc (DVD), floppy disk, and Blu-ray disc, where disks usually reproduce data magnetically, whereas discs reproduce data optically utilizing lasers. Combinations of the above ones should also be included in the scope of computer-readable media.

Software modules may be configured to reside in RAM memory, flash memory, ROM memory, EPROM memory, EEPROM memory, registers, hard disk, removable disk, CD-ROM, and/or any other form of well-known storage medium. An example storage medium may be coupled to a processor, so that the processor may read information from or write information to the storage medium. The processor and storage medium may be present within an ASIC. The ASIC may be present in a user terminal. In other embodiments, the processor and storage medium may be present as separate components in the user terminal.

Although the above-described embodiments have been described as utilizing aspects of the subject matter disclosed herein on one or more standalone computer systems, the disclosure is not limited thereto and may also be implemented in conjunction with any computing environment such as a network or distributed computing environment. Furthermore, aspects of the subject matter of this disclosure may be implemented with multiple processing chips and/or devices, and storage may be similarly effected across the multiple devices. These devices may include PCs, network servers, and/or portable devices.

Although the present disclosure has been described above with respect to embodiments thereof, the present disclosure is not limited thereto. Various modifications and variations can be made thereto by those skilled in the art within the scope of the present disclosure and the equivalent scope of the appended claims.

### DESCRIPTION OF SOME REFERENCE SYMBOLS

110: cell
120: charger
130: sensor
140: negative electrode
142: silicon
144: graphite

## Claims

1. A method (1100) for detecting a defective cell, the method comprising:
charging (S1110) a cell (110) in a manner that a state of charge (SOC) of the cell (110) falls within a reference range;
obtaining (S1120) first charge data comprising differential voltage information of a negative electrode (140) of the cell (110) while the cell (110) is being charged, wherein the negative electrode (140) comprises graphite (144) and silicon (142);
calculating (S1130) a charging parameter associated with the silicon (142) of the negative electrode (140) based on the first charge data; and
determining (S1140) whether the cell (110) is defective based on the charging parameter associated with the silicon (142).

2. The method as claimed in claim 1, further comprising outputting information related to the cell (110) in response to determining that the cell (110) is defective.

3. The method as claimed in claim 1 or claim 2, wherein the charging parameter associated with the silicon (142) is associated with a state of electrolyte impregnation of the negative electrode (140).

4. The method as claimed in any of claims 1-3, wherein a C-rate during charging of the cell (110) is higher than a reference threshold.

5. The method as claimed in any preceding claim, wherein the charging parameter associated with the silicon (142) is determined based on a reference value and differences between differential voltage values of the negative electrode (140) in the reference range of the cell (110).

6. The method as claimed in claim 5, wherein:
the determining whether the cell (110) is defective comprises determining whether the cell (110) is defective based on the charging parameter associated with the silicon (142) and a reference threshold; and
the reference threshold is determined based on a capacity retention ratio according to an electrolyte content.

7. The method as claimed in any preceding claim, wherein the charging parameter associated with the silicon (142) comprises a silicon-dominant response peak.

8. The method as claimed in any preceding claim, wherein the reference range is a SOC range of 85 percent or higher.

9. The method as claimed in any preceding claim, wherein the cell (110) is a cell that has undergone a formation process.

10. The method as claimed in claim 9, further comprising applying a re-formation process to the cell (110) in response to determining that the cell (110) is defective.

11. The method as claimed in claim 10, further comprising, after the re-formation process of the cell (110):
obtaining second charge data; and
determining whether the cell (110) is defective based on the second charge data.

12. A system for detecting a defective cell, the system comprising:
a communication module;
a memory; and
at least one processor connected to the memory and configured to execute instructions stored in the memory to cause the at least one processor to perform a method comprising: charging a cell in a manner that a state of charge (SOC) of the cell (110) falls within a reference range;
obtaining first charge data comprising differential voltage information of a negative electrode of the cell (110) while the cell (110) is being charged, wherein the negative electrode (140) comprises graphite (144) and silicon (142);
calculating a charging parameter associated with the silicon (142) of the negative electrode based on the first charge data; and
determining whether the cell (110) is defective based on the charging parameter associated with the silicon (142).

13. The system as claimed in claim 12, wherein the instructions cause the at least one processor to perform the method further comprising:
outputting information related to the cell (110) in response to determining that the cell (110) is defective.

14. The system as claimed in claim 12 or claim 13, wherein the charging parameter associated with the silicon (142) is associated with a state of electrolyte impregnation of the negative electrode.

15. The system as claimed in any of claims 12 to 14, wherein a C-rate during charging of the cell (110) is higher than a reference threshold.
